# DEMANDE DE BREVET EUROPEEN

(11) **EP 1 995 601 A1**
(43) Date de publication de la demande: **26.11.2008**
(21) Numéro de dépôt: 08370011.2
(22) Date de dépôt: 21.05.2008
(51) Int. Cl.: G01R 31/02, F16P 3/00, F16P 7/00

(54) **Répartiteur pour des capteurs détecteurs de proximité**

(30) Priorité: 24.05.2007 FR 0703688
(71) Demandeur: Maprotec Société Anonyme, 59810 Lesquin (FR)
(72) Inventeur: Rigaut, Roger, 59152 Anstaing (FR)
(74) Mandataire: Duthoit, Michel Georges André

(57) **Abrégé**

L'invention est relative à un répartiteur (1) permettant la réalisation de connexions électriques entre un et plusieurs capteurs détecteurs de proximité, notamment de type inductif, et une machine telle que par exemple une presse via un câble de raccordement. Le répartiteur présente une pluralité d'embases « capteur » (2) ainsi que notamment une embase « machine » (3).

Selon l'invention, le répartiteur présente, pour chaque embase capteur (2), des moyens pour le contrôle de la connexion d'un capteur détecteur de proximité dit répartiteur constitué par :
- un élément de signalisation (4),
- des moyens pour détecter la présence d'un courant de fuite (i_{f}) dans ledit capteur correspondant,
- des moyens de commutation pour activer ledit élément de signalisation (4) dans le cas de la détection d'un courant de fuite ou le laisser au repos dans le cas contraire.

## Description

L'invention concerne un répartiteur et trouvera une application particulière pour connecter électriquement un ou plusieurs capteurs détecteurs de proximité, notamment de type inductif à une machine, telle que notamment une presse, via un câble de raccordement.

Dans ce domaine, il est connu des répartiteurs se présentant sous la forme de boîtiers autonomes. Une pluralité d'embases « capteur », notamment femelles, permet le branchement des embouts mâles des câbles des capteurs détecteurs de proximité inductifs. Une embase « machine », notamment mâle, permet le branchement d'un embout femelle du câble de la machine.

Ce répartiteur connu trouve une application particulière pour relier des capteurs détecteurs de proximité, inductifs à une presse. Ces détecteurs de proximité sont positionnés au niveau de la matrice de la presse, afin de s'assurer du bon positionnement de la pièce métallique à emboutir.

Aussi, pour des raisons de sécurité, le poinçon de la presse n'est actionné que dans la condition où tous les détecteurs de proximité sont activés. Si l'un des capteurs ne détecte pas la pièce métallique, la presse est inhibée. Dans le cas d'une mauvaise connexion ou encore dans le cas d'un capteur défectueux, la presse ne peut fonctionner. Il est alors nécessaire de trouver l'origine de la panne.

Jusqu'à présent, les branchements des câbles audit répartiteur doivent être vérifiés un par un. Il en est de même pour les capteurs détecteurs de proximité qui doivent être testés l'un après l'autre afin de découvrir le ou les capteurs défectueux.

Le but de la présente invention est de pallier tout ou partie des inconvénients précités, notamment en proposant un répartiteur permettant de s'assurer de la réalité des connexions électriques.

Un autre but de la présente invention est de proposer un tel répartiteur, alimenté en énergie par la machine à laquelle il est rattaché, peu gourmand en énergie.

Un autre but de la présente invention est de proposer un répartiteur permettant de s'assurer du bon fonctionnement de chaque capteur connecté.

D'autres buts et avantages de la présente invention apparaîtront au cours de la description qui va suivre qui n'est donnée qu'à titre indicatif et qui n'a pas pour but de la limiter.

L'invention concerne un répartiteur permettant la réalisation de connexions électriques entre un ou plusieurs capteurs détecteurs de proximité, notamment de type inductif, et une machine, telle que par exemple une presse, notamment via un câble de raccordement, ledit répartiteur présentant une pluralité d'embases « capteur » ainsi que notamment une embase « machine ».

Selon l'invention, ledit répartiteur présente, pour chaque embase capteur, des moyens pour le contrôle de la connexion d'un capteur détecteur de proximité audit répartiteur, constitué par :
- un élément de signalisation,
- des moyens pour détecter la présence d'un courant de fuite dans ledit capteur correspondant,
- des moyens de commutation pour activer ledit élément de signalisation dans le cas de la détection d'un courant de fuite ou le laisser au repos dans le cas contraire.

L'invention sera mieux comprise à la lecture de la description suivante accompagnée des dessins en annexe parmi lesquels :
- la figure 1 est une vue de dessus d'un répartiteur conforme à l'invention, selon un mode de réalisation, prenant la forme d'un boîtier autonome,
- la figure 2 illustre un schéma électrique du répartiteur tel qu'illustré à la figure 1,
- la figure 3 illustre une partie du circuit tel qu'illustré à la figure 2, associé à une embase capteur, respectivement lorsqu'aucun capteur n'est branché à l'embase capteur,
- la figure 4 illustre une partie du circuit tel qu'illustré à la figure 2, associé à une embase capteur lorsqu'un capteur est branché à l'embase capteur dans un état non activé,
- la figure 5 illustre une partie du circuit tel qu'illustré à la figure 2, associé à une embase capteur lorsqu'un capteur est branché à l'embase capteur et dans un état activé, c'est-à-dire détectant la proximité d'un objet.

L'invention concerne un répartiteur 1 permettant la réalisation de connexions électriques entre un ou plusieurs capteurs détecteurs de proximité, notamment de type inductif, et une machine telle que par exemple une presse, notamment via un câble de raccordement.

Le répartiteur présente une pluralité d'embases « capteur » 2, ainsi que notamment une embase « machine » 3. Il est à noter que cette dernière embase « machine » peut ne pas exister et alors, le boîtier est raccordé directement, par exemple par une connexion filaire.

Il peut ainsi se présenter sous la forme d'un boîtier autonome ou encore être intégré directement à ladite machine, faisant corps avec cette dernière.

Selon l'invention, le répartiteur présente, pour chaque embase capteur 2, des moyens pour le contrôle de la connexion d'un capteur détecteur de proximité audit répartiteur, constitué par :
- un élément de signalisation 4,
- des moyens pour détecter la présence d'un courant de fuite i_{f} dans ledit capteur correspondant,
- des moyens de commutation pour activer ledit élément de signalisation 4 dans le cas de la détection d'un courant de fuite ou le laisser au repos dans le cas contraire.

Selon un mode de réalisation, ledit élément de signalisation 4 est une source lumineuse ou encore une source sonore.

Selon un mode de réalisation, lesdits moyens pour détecter un courant de fuite et lesdits moyens de commutation peuvent être constitués par un élément amplificateur commandé par ledit courant de fuite i_{f}.

Par exemple, ledit élément amplificateur est un transistor 5 dont la base est attaquée par ledit courant de fuite. Avantageusement, ledit élément amplificateur est alimenté en énergie via la machine. Notamment, le transistor 5 est polarisé au moyen de deux lignes de tension V⁺, V⁻ associées chacune à une borne 6, 7 de la machine 3.

Chaque embase capteur 2 peut présenter au moins deux bornes 8, 9, l'une 8 de ses bornes étant connectée à la ligne V⁺ via une ou plusieurs diodes 10, l'autre 9 de ses bornes étant connectée à une borne 11 de la machine 3.

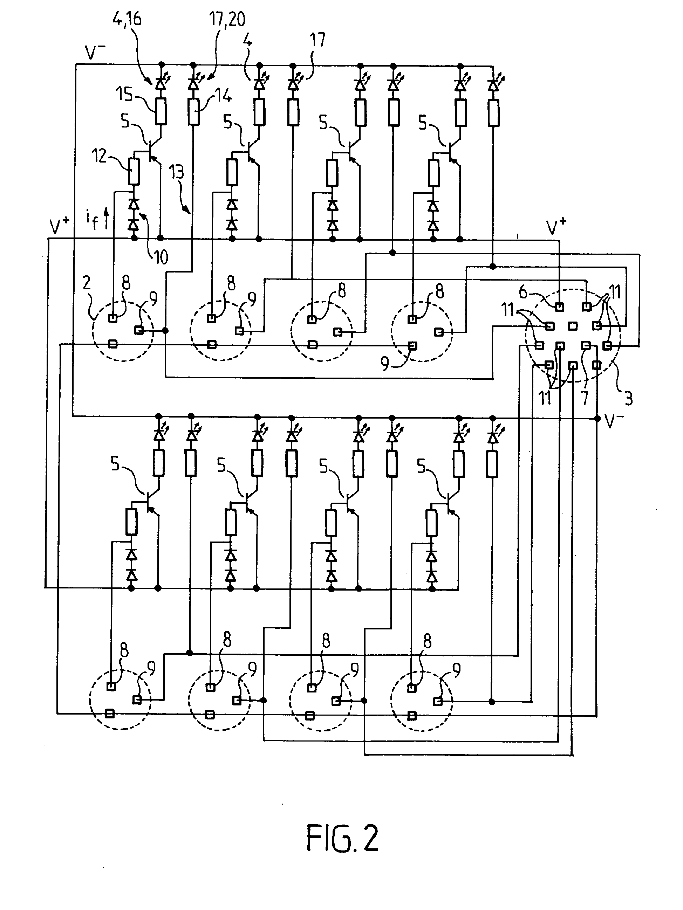

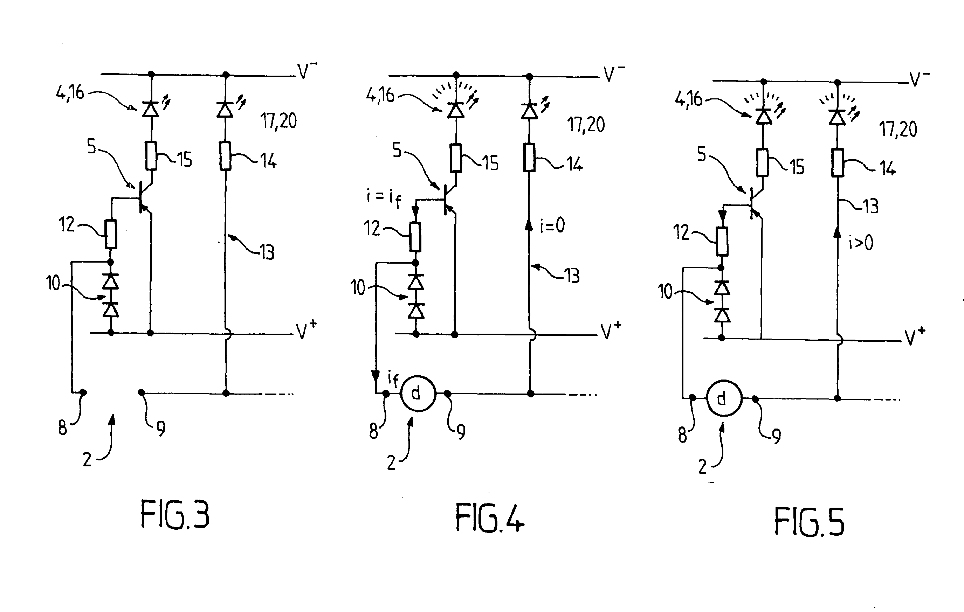

Selon un exemple de réalisation illustré aux figures 2 et 3 notamment, le transistor 5 est de type PNP. L'une 8 des bornes de l'embase capteur 2 est connectée d'une part, à la base du transistor 5 via une résistance 12, et d'autre part à ladite ligne de tension V⁺ via la ou les diodes 10.

L'autre 9 des bornes de l'embase capteur 2 est connectée, d'une part, à la ligne V⁻ via une ligne de dérivation 13 comprenant au moins une résistance 14, et d'autre part, à l'une 11 des bornes de la machine 3. L'émetteur dudit transistor est connecté à ladite ligne de tension V⁺, le collecteur dudit transistor 5 étant connecté à la ligne de tension V via une résistance 15 et une diode électroluminescente 16. La diode électroluminescente 16 constitue ledit élément de signalisation 4.

Cet exemple de réalisation fonctionne de la manière suivante :
- Lorsqu'aucun capteur n'est branché à l'embase capteur 2, telle qu'illustrée à la figure 3, ou encore lorsque la connexion est mauvaise, le courant est nul à la base du transistor 5. Le transistor 5 est donc bloqué. La diode électroluminescente 16 reste donc éteinte.
- Lorsqu'un capteur détecteur de proximité est branché à son embase capteur 2, dans un état non actif, tel qu'illustré à la figure 4, il existe un courant de fuite non nul à la base du transistor 5. Ce courant de fuite i_{f} est donc amplifié par le transistor 5 pour alimenter la diode électroluminescente 16 qui s'allume ; le courant traversant la ligne de dérivation est nul ; l'éventuelle diode électroluminescente 17, qui, nous le verrons par la suite, témoigne de l'état du capteur, reste donc éteinte.
- Lorsqu'un capteur est branché à l'embase capteur 2, dans un état actif, tel qu'illustré à la figure 5, un courant bien supérieur au courant de fuite traverse les deux bornes 8, 9 de l'embase ; la base du transistor 5 est attaquée par une petite partie de ce courant qui est amplifié par le transistor 5 pour allumer la diode électroluminescente 16. La plus grande partie du courant traversant les bornes 8, 9 et passe par la ligne de dérivation 13 via les diodes 10. Cette ligne de dérivation 13 permet ainsi de limiter la consommation en énergie, en évitant notamment de saturer le transistor 5. Dans le cas d'une éventuelle diode 17 placée sur la ligne de dérivation 13, celle-ci s'allume, témoignant de l'état activé du capteur détecteur de proximité.

Par ailleurs, ledit élément de signalisation 4 est dit premier élément de signalisation, ledit répartiteur 1 présentant, en outre, pour chaque embase capteur 2, des moyens pour le contrôle de l'état du capteur détecteur de proximité connecté à cette embase.

Selon ce mode de réalisation, les moyens pour le contrôle de l'état du capteur détecteur de proximité sont constitués substantiellement par un second élément de signalisation 20 qui indique si ledit capteur détecteur de proximité détecte un objet ou reste au repos dans le cas contraire.

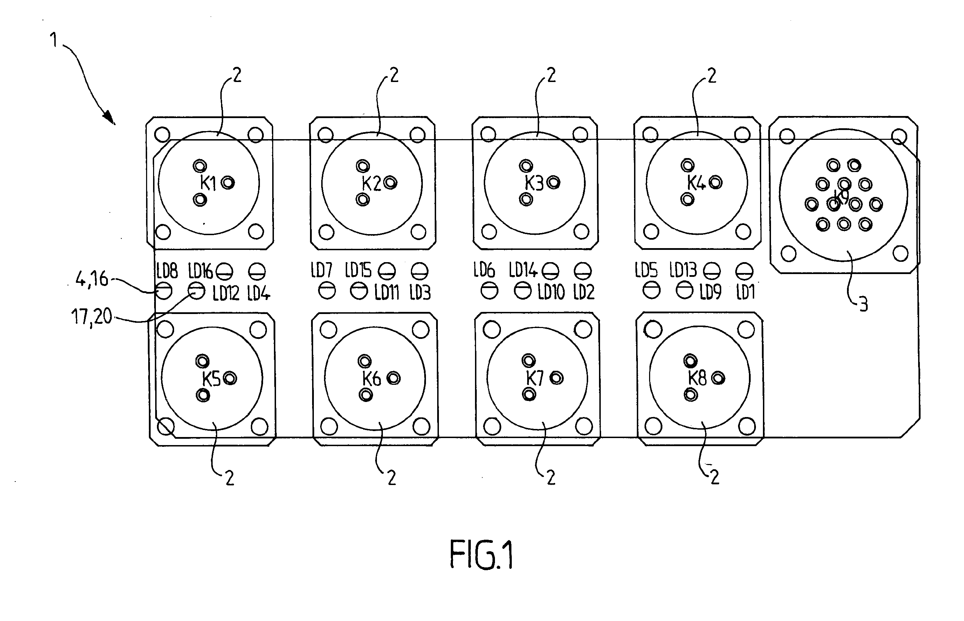

Selon un mode de réalisation, ledit second élément de signalisation 20 est une source lumineuse ou encore une source sonore. Notamment tel qu'illustré aux figures 1 à 4, selon un exemple de réalisation, le second élément de signalisation 20 est constitué par la diode électroluminescente 17 sur ladite ligne de dérivation 13.

Naturellement, d'autres modes de mise en oeuvre, à la portée de l'homme de l'art, auraient pu être envisagés sans pour autant sortir du cadre de l'invention définie par les revendications ci-après.

## Revendications

1. Répartiteur (1) permettant la réalisation de connexions électriques entre un ou plusieurs capteurs détecteurs de proximité, notamment de type inductif, et une machine, telle que par exemple une presse, notamment via un câble de raccordement, ledit répartiteur présentant une pluralité d'embases « capteur » (2), ainsi que notamment une embase « machine » (3), **caractérisé en ce que** ledit répartiteur présente, pour chaque embase capteur, des moyens pour le contrôle de la connexion d'un capteur détecteur de proximité audit répartiteur, constitués par :
- un élément de signalisation (4),
- des moyens pour détecter la présence d'un courant de fuite (i_{f}) dans ledit capteur correspondant,
- des moyens de commutation pour activer ledit élément de signalisation (4) dans le cas de la détection d'un courant de fuite ou le laisser au repos dans le cas contraire.

2. Répartiteur selon la revendication 1, dans lequel ledit élément de signalisation (4) est une source lumineuse ou encore une source sonore.

3. Répartiteur selon la revendication 1 ou 2, dans lequel lesdits moyens pour détecter un courant de fuite et lesdits moyens de commutation sont constitués par un élément amplificateur commandé par le courant de fuite (i_{f}).

4. Répartiteur selon la revendication 3, dans lequel l'élément amplificateur est un transistor (5) dont la base est attaquée par ledit courant de fuite.

5. Répartiteur selon la revendication 4, dans lequel le transistor (5) est polarisé au moyen de deux lignes de tension V⁺, V⁻ associées chacune à une borne (6, 7) de la machine (3).

6. Répartiteur selon la revendication 5, dans lequel chaque embase capteur (2) présente au moins deux bornes (8, g), l'une (8) de ses bornes étant connectée à la ligne V⁺ via une ou plusieurs diodes (10), l'autre (9) de ses bornes étant connectée à une borne (11) de la machine (3).

7. Répartiteur selon la revendication 6, dans lequel le transistor (5) est de type PNP, l'une (8) des bornes de l'embase capteur (2) étant connectée, d'une part, à la base du transistor (5) via une résistance (12), et d'autre part à ladite ligne de tension V⁺ via la ou les diodes (10), l'autre (9) de ses bornes étant connectée, d'une part, à la ligne V⁻ via une ligne de dérivation (13) comprenant au moins une résistance (14), et d'autre part, à l'une (11) des bornes de la machine (3), l'émetteur dudit transistor (5) étant connecté à la ligne de tension V⁺, le collecteur dudit transistor (5) étant connecté à la ligne de tension V via une résistance (15) et une diode électroluminescente (16), ladite diode électroluminescente (16) constituant ledit élément de signalisation (4).

8. Répartiteur selon l'une des revendications 1 à 7, dans lequel ledit élément de signalisation (4) est dit premier élément de signalisation, ledit répartiteur (1) présentant, en outre, pour chaque embase capteur (2), des moyens pour le contrôle de l'état du capteur détecteur de proximité connecté à cette embase, lesdits moyens pour le contrôle étant constitués substantiellement par un second élément de signalisation (20) qui indique si ledit capteur détecteur de proximité détecte un objet ou reste au repos dans le cas contraire.

9. Répartiteur selon la revendication 8, dans lequel ledit second moyen de signalisation est une source lumineuse ou encore une source sonore.

10. Répartiteur selon les revendications 7 et 8, dans lequel ladite ligne de dérivation (13) comprend, outre la résistance (14), une diode électroluminescente (17) constituant ledit second élément de signalisation (20).
